# EUROPEAN PATENT SPECIFICATION

(11) **EP 4 350 364 B1**
(45) Date of publication and mention of the grant of the patent: **02.12.2026**
(21) Application number: 23201392.0
(22) Date of filing: 03.10.2023
(51) Int. Cl.: G01R 21/133, G01R 22/06

(54) **SYSTEM AND METHOD OF VIRTUALIZED ENERGY METERING FOR INTELLIGENT POWER DISTRIBUTION EQUIPMENT**
SYSTEM UND VERFAHREN ZUR VIRTUALISIERTEN ENERGIEMESSUNG FÜR INTELLIGENTE STROMVERTEILUNGSAUSRÜSTUNG
SYSTÈME ET PROCÉDÉ DE MESURE D'ÉNERGIE VIRTUALISÉE POUR ÉQUIPEMENT DE DISTRIBUTION D'ÉNERGIE INTELLIGENT

(30) Priority: 04.10.2022 US 202263413108 P; 20.09.2023 US 202318370573
(43) Date of publication of application: 10.04.2024
(73) Proprietor: Vertiv Corporation, Westerville, OH 43082 (US)
(72) Inventor: FERGUSON, Kevin R., DUBLIN, OH (US); ALDAG, Philip R., COLUMBUS, OH (US); ROSAS, Rodolfo, AUSTIN, TX (US); ARMSTRONG, Jason, LINCOLN, NE (US)
(74) Representative: Kilburn & Strode LLP

(56) References cited:
- US-A1- 2010 191 487
- US-A1- 2014 333 286
- US-A1- 2015 276 825
- US-A1- 2015 362 941
- US-A1- 2018 196 098
- US-B2- 9 568 507

## Description

The present disclosure generally relates to the field of energy metering for power distribution systems, and more particularly to virtualized energy metering for intelligent power distribution equipment.

US 2014/333286 A1 discloses a branch circuit monitor with a processor and external metering modules that convert analog signals to digital data. US 2018196098 A1 discloses a method to detect residual current and identify its associated voltage phase and outlet. US 2015/276825 A1 discloses a cloud-based power quality monitoring system that continuously measures, buffers, and transmits power quality data to cloud-based servers. US 2010/191487 A1 discloses an energy monitoring device that can identify electrical devices and their states to provide detailed energy usage information. US 9 568 507 B2 discloses a wireless distributed energy metering system that broadcasts voltage reference data to wirelessly connected metering units. Designs for power, switching and distribution (PSD) systems within data centers are physically constrained by electrical current/power metering requirements. For example, some metering requirements necessitate the positioning of current transformers at system inputs and/or output distribution sites.

The analysis of current/power usage derived from these discrete PSD systems or PSD infrastructure networks (e.g., groups of remote power panels, busway tap-off boxes, and/or PSD systems), either require dedicated hardware and processing elements at each power distribution node or, in lieu of that, are often estimated, e.g., via arithmetic summation of calculated RMS values, which could be grossly inaccurate for loads having low harmonic or displacement power factor. These estimated methods for tracking current/power usage also limit the ability of a service to accurately segment usage when managing multiple customers within a data center or business. As such, it would be advantageous to provide a system or apparatus to remedy the shortcomings of the conventional approaches identified above.

Accordingly, the present invention is directed to a system and method for virtualized energy metering. The virtualized energy metering is performed via a power distribution system including power modules that include voltage and/or current sensing circuitry. Each power module includes a processor unit configured to transform incoming analog signals into time-correlated digital data. The data captured by a first power module are sent to a second power module that further analyzes and/or aggregates the digital data and reports out the analyzed/aggregated data to a user, including aggregated energy-related parameters. The system and method may facilitate the efficient sensing, measurement, and calculation of energy metering parameters, with greater optimization of monitoring resources, reduced complexity of hardware, and lower solution costs.

It is to be understood that both the foregoing general description and the following detailed description are exemplary and explanatory only and are not necessarily restrictive of the present invention. The accompanying drawings, which are incorporated in and constitute a part of the specification, illustrate subject matter of the invention. Together, the descriptions and the drawings serve to explain the principles of the invention.

The numerous advantages of the invention may be better understood by those skilled in the art by reference to the accompanying figures.
FIG. 1 is a block diagram of a power distribution system which may be configured to utilize virtualized energy metering, in accordance with the invention.
FIG. 2 is a block diagram of a power input module (PIM) in accordance with the present invention.
FIG. 3 is a block diagram of an interchangeable monitoring device (IMD) in accordance with the invention.
FIG. 4 is a block diagram of a power input module (PIM) in accordance with the present invention.
FIG. 5 is a block diagram of the power distribution system with multiple interchangeable monitoring devices (IMDs) communicatively linked or otherwise have interconnectivity with each other, in accordance with the present invention.
FIG. 6 is a graph of discrete and aggregate determination of current waveforms, in accordance with the present invention.
FIG. 7 is a flow diagram illustrating a method for virtualizing energy metering, in accordance with the invention.

Reference will now be made in detail to the subject matter disclosed, which is illustrated in the accompanying drawings.

Before explaining the invention in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the invention. However, it will be apparent to one of ordinary skill in the art having the benefit of the instant invention that the embodiments disclosed herein may be practiced without some of these specific details. In other instances, well-known features may not be described in detail to avoid unnecessarily complicating the instant invention.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the invention in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant invention

Accordingly, the present invention is directed to a system and method for virtualized energy metering. The virtualized energy metering allows users to segment and accurately aggregate current and virtualize energy metering of power distribution systems, such as busways, remote power panels (RPP), power distribution units (PDU), static switch systems, and other control systems. The virtualized energy metering also enhances management of PSD systems, PSD applications, and connected loads. Systems performing virtualized energy metering may include specific metering componentry and/or software within tap box units that collect, coordinate, and correlate the voltage and current waveforms measured independently between tap boxes on a busway run and aggregating the individual current waveforms associated with the same phase. In this manner, the per feed-in phase RMS currents and per phase and overall 'virtualized' energy metering of the feed-in unit can be accurately calculated without requiring the additional hardware and processing elements installed at the feed-in unit.

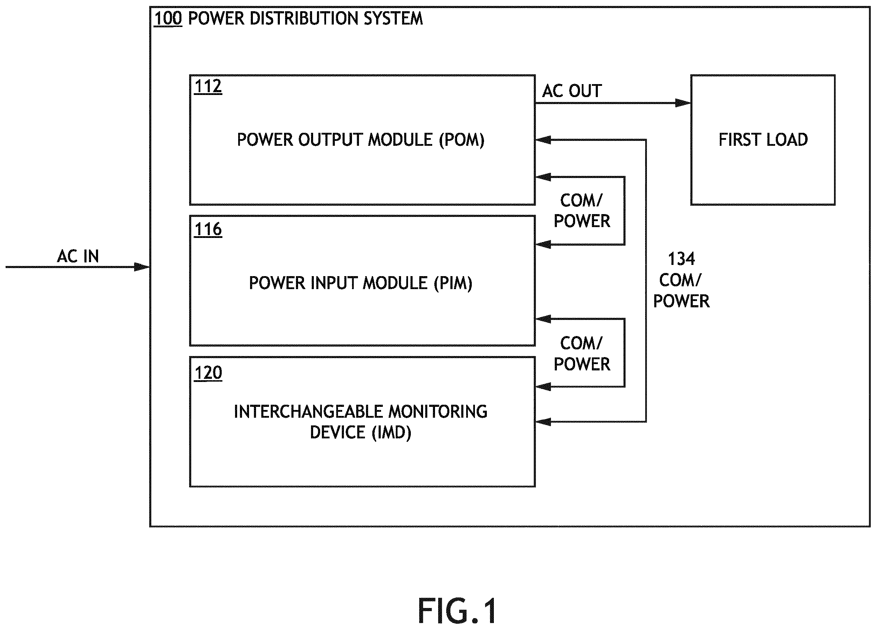

Referring to FIG. 1, a block diagram of a power distribution system 100 which may be configured to utilize virtualized energy metering, in accordance with the invention is shown. It is contemplated that the power distribution system 100 may be part of a busway and tap box electrical system, a remote power panel, or a remote power distribution unit. The power distribution system 100 may receive an input alternating current (AC in), and outputs power (AC out) to a first load, which includes a plurality of power receptacles/outlets that powers a set, or sets, of rack mounted assets (e.g., servers). The control circuitry of the power distribution system 100 is divided into several sections, or power modules, that control and/or monitor power (e.g., current and/or voltage), including a power output module (POM) 112, a power input module (PIM) 116 that monitors incoming power, and an interchangeable monitoring device (IMD) 120 that receives data from the POM 112 and PIM 116, and monitors power conditions.

The POM 112, PIM 116, and IMD 120, each may be referred as a power module, and may be operatively coupled via communication buses 134 that allow the modules to communicate with each other. Further details of the power distribution system 100 are disclosed in United States Patent Application Serial Number 18/198,504 entitled "OUTLET IN-RUSH CURRENT LIMITER FOR INTELLIGENT POWER STRIP" filed on May 17, 2023 by Kevin Ferguson, Casey Gilson, Scott Cooper, and Jason Armstrong. The power distribution system 100 is one of many devices which can be configured to utilize the system and method for virtualized energy monitoring. Therefore, the description herein is intended as an illustration of the system and method and not as a limitation.

The power distribution system 100 may include multiple POMs 112, PIMs 116, and IMDs 120 such that each receptacle, or groups or receptacles, may be monitored and/or controlled by specific POMs 112, PIMs 116, and IMDs 120. The POMs 112, PIMs 116, and IMDs 120 may be operatively coupled such that the power distribution system 100 may be able to track and/or control each receptacle, or set of receptacles, individually and/or in aggregate as described herein.

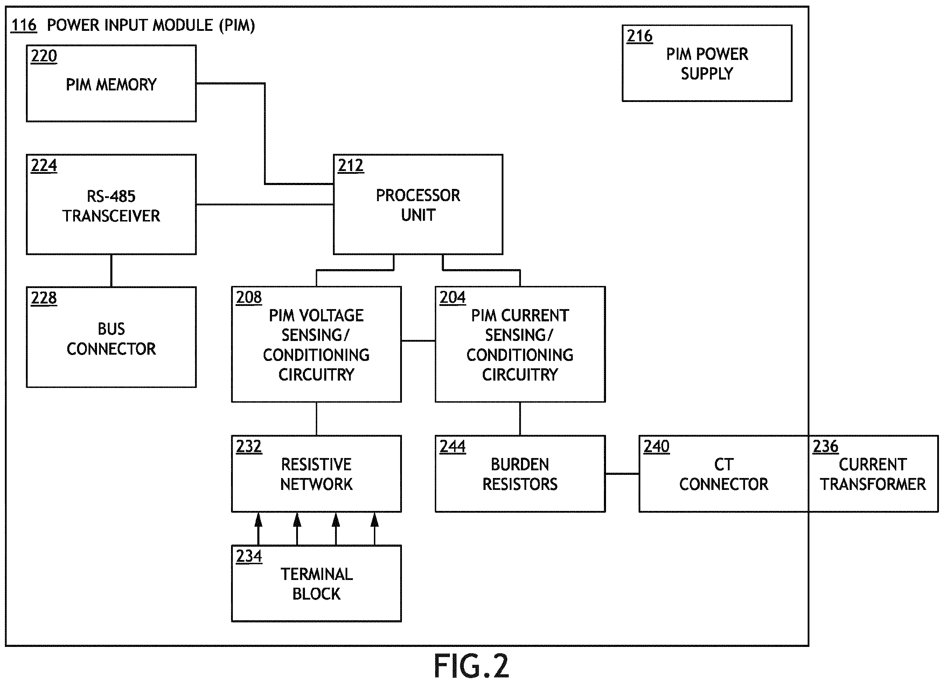

Referring to FIG. 2, a block diagram of a power input module (PIM) 116 in accordance with the present invention is shown. It is contemplated that the PIM 116 measures input voltages and input currents and calculates energy metering data for the inputs and branch circuits of the power distribution system 100. The PIM 116 may detect and measure voltages and currents via a sensing subsystem. For example, the PIM 116 may include PIM current sensing/conditioning circuitry 204, and PIM voltage sensing/conditioning circuitry 208. The PIM 116 may also include one or more processor unit 212, a PIM power supply 216, and a PIM memory 220. The PIM 116 may communicate with the IMD 120 via an RS-485 physical layer and/or other proprietary protocol (e.g., communication interface or bus connector 228). For example, the IMD 120 may communicate with PIMs 116 and/or POMs 112 to receive metering data.

The voltage sensing/conditioning circuitry 208 may be operatively coupled to one or more resistive attenuation networks (e.g., resistor network 232) that are connected to the pole and neutral of each primary circuit (e.g., via a terminal block 234). For example, the PIM voltage sensing conditioning circuitry 208 may be coupled to four resistor networks 232. The resistor networks 232 may comprise resistor strings connected in series. For example, the resistor strings may include 0.5W/200V resistors. In another example, the resistor strings may include 2MΩ resistors. The resistor string may include a non-safety extra-low voltage (non-SELV) portion (e.g., the 2MΩ resistors) and a SELV portion (e.g., a 1kΩ shunt resistor) that is grounded to functional earth.

The resistor string may provide an attenuation factor, or a range of attenuation factors for operation (e.g., within the common-mode range of the signal conditioning circuitry). For example, the resistor string may provide approximately 2000:1 attenuation, approximately 4000:1 attenuation, approximately 8000:1 attenuation, approximately 16000:1 attenuation, or approximately 32000:1 attenuation. Voltage sensing/conditioning circuitry 208 may also include a shunt resistor, wherein current may be transduced through the shunt resistor to a voltage with a single amplifier stage, with an output conditioned to a respective ADC input. The signal conditioning stage may also utilize a single difference amplifier with gain to provide high common mode rejection of input voltage transients.

The PIM current sensing/conditioning circuitry 204 includes, or is operatively coupled to, one or more current transformers 236. For example, the one or more current transformers 236 may be external to the PIM 116 and coupled to the PIM 116 via CT connectors 240. Input from the one or more current transformers 236 may pass through the CT connectors and a set of burden resistors 244 before the input is passed through to the PIM current sensing/conditioning circuitry 204.

The one or more current transformers 236 may include any type of current transformer including but not limited to a toroidal current transformer. For example, the one or more current transformers may include a toroidal current transformer of a flying-leaded type with a cable terminated to a 2.0 mm pitch 2-pin connector plug. The one or more current transformers may be configured with any number of turns ratios including but not limited to a 500:1 turns ratio, a 1000:1 turns ratio, a 2000:1 turns ratio, a 2500:1 turns ratio, a 3000:1 turns ratio, or a 4000:1 turns ratio. The one or more current transformers 236 may be coupled with a line or load side of a single pole of an overcurrent protective device (OCPD) branch circuit conductor, or with some other conductor feeding the outlet circuits.

The burden resistors 244 may be soldered onto a substrate of the PIM 116 (e.g., to a printed circuit board (PCB) or printed wiring board (PWB)). The burden resistors 244 may also be rated to handle several times (e.g., 10 times) the current rating for one second under a short circuit fault without hazardous voltage interruption (e.g., as per § 16.1 of UL/IEC 61010-1). In embodiments, the PIM current sensing/conditioning circuitry 204 induces the burden resistors 244 through dual single stage first order low-pass resistor-capacitor (RC) filters (e.g., RC Butterworth filters), and outputs the conditioned signals to their respective single-ended ADC inputs.

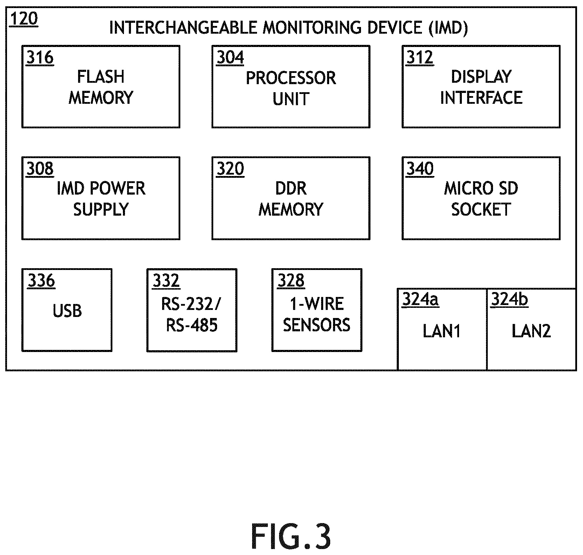

Referring to FIG. 3, a block diagram of an interchangeable monitoring device (IMD) 120, in accordance with the invention is shown. The IMD 120 may be configured as a hot-swappable web card which is installed in the power distribution system 100. The IMD 120 may include one or more processor units 304, an IMD power supply 308, a display interface 312, and also a non-volatile (NV) memory in the form of flash memory 316 and/or DDR memory 320. The IMD 120 may also include a plurality of ports including, but not limited to, one or more LAN Ethernet ports 324a-b, one or more 1-wire sensor ports 328, an RS-232/RS-485 port 332, a USB port 336, and a microSD socket 340. The IMD 120 may also communicate with other RPDU componentry via an RS-485 physical layer.

The IMD 120 may serve as the monitoring host controller for the power distribution system 100, and may be in constant communication with the POM 112 and/or PIM 116. By communicating with the POM 112 and/or PIM 116, the IMD 120 may provide a means for the user to enable or disable one or more features of the power distribution system 100, as well as acquire and display status information. In embodiments, the IMD 120 does not directly sense the receptacle voltage and/or execute connection or disconnection algorithms (e.g., the voltage sensing and execution may be performed by the POM 112 and/or PIM 116).

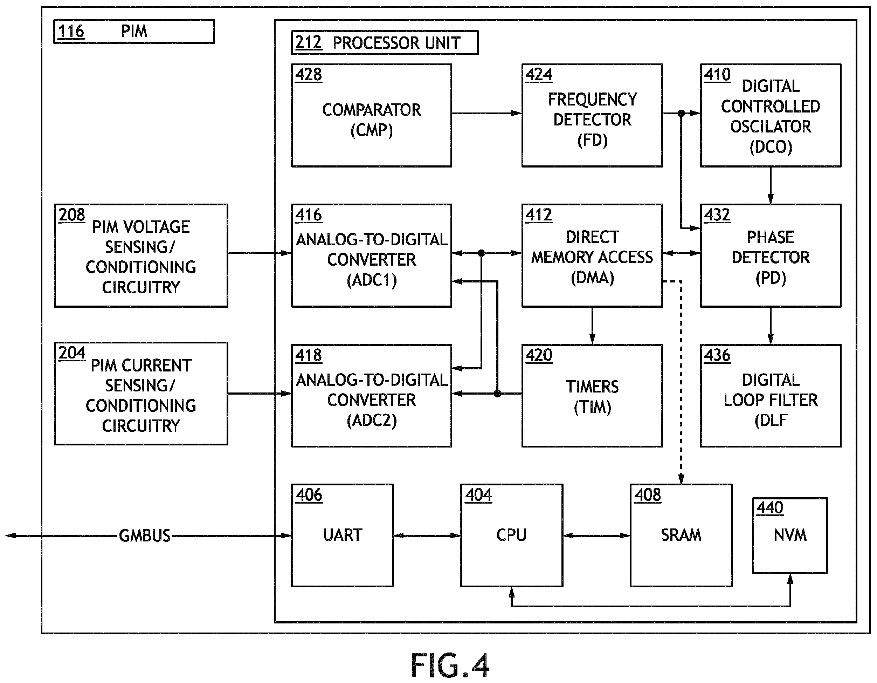

Referring to FIG. 4, a block diagram of a power input module (PIM) 116 in accordance with the present invention is shown. The PIM may include a processor unit 212 which may communicate with the PIM voltage sensing/conditioning circuitry 208 and the PIM current sensing/conditioning circuitry 204, in accordance with the invention. The processor unit 212 may include a microcontroller (MCU) or may include a microprocessor (MPU). The processor unit 212 includes, or maybe operatively coupled to, one or more processors (e.g., central processing units (CPU) 404 and other circuitry) that capture, measure, and transform data and send the collected and transformed date to the IMD 120 (e.g., via a universal asynchronous receiver/transmitter (UART) 406, or other data transfer technology). Voltage and current sensor measurements may be recorded to volatile memory (e.g., SRAM) and transformed prior to use for data analysis. The processor unit 212 and related circuitry may include a phase lock loop (PLL) that establishes the time-base and capture-rate periodicity of the waveforms from measured voltages and currents while preserving mutual phase relationships. The PLL may be formed from the frequency detector 424, digital controlled oscillator 410, phase detector 432, digital loop filter 436, and timers 420, along with other circuitry elements of the processor unit 212. It is contemplated that the digital controlled oscillator (DCO) 410 may use a free-running, up counter (e.g., 16-bit) with nanosecond (ns) timing resolution per count. In one example, the DCO 410 may be configured with an approximately 300 ns timing resolution per count. It is contemplated that the phase lock loop may allow for the time correlation and aggregation of times series data of the different modules.

In embodiments, the PLL may use multiple, linked direct memory access channels (DMA 412) to facilitate locking onto line frequency, triggering ADC conversion from one or more analog-digital converters (ADCs) 416, 418 that receive inputs from the PIM voltage sensing/conditioning circuitry 208 and PIM current sensing/conditioning circuitry 204. The ADCs may be configured for any type of data/ADC conversion including but not limited to 16-bit conversion. The PLL may also utilize the DMA 412 to facilitate transferring time-ordered samples (e.g., also known as a time series) to SRAM 408. The PLL saves N-cycle timer series data streams into circular buffers.

In embodiments, the PLL modifies the modulus of a sequential chain of programmable precision delay timers 420. These timers 420 are configured to trigger one or more ADCs 416, 418 upon a predefined result. For example, the timers 420 may trigger one or more ADCs 416, 418 after a counter expires when the modulus is reached. For instance, the timers 420 may trigger the ADCs 416, 418, which convert in an interleaving fashion and a maximum samples per second (ksps) per channel. In particular, the ADCs 416, 418 may convert at approximately 15.36 ksps per channel per 2^{N} V-I sensing channels (e.g., 256 samples per channel per line cycle at 60 Hz line frequency).

In embodiments, the processor unit 212 includes a frequency detector 424 and a comparator 428. The frequency detector 424 uses the comparator 428 to register occurrences of voltage zero-crossings detected from the output of the PIM voltage sensing/conditioning circuitry 208. The comparator 428 may be configured with hysteresis and digital filtering to trigger upon detection of rising edges at a threshold (e.g., 100 mV) above the voltage zero-crossing. The comparator 428 may also be configured to record via the DMA 412 instantaneous DCO counts. The frequency detector 424 may also be configured to calculate a first order difference of successively recorded DCO counts and digitally filter the result to produce a DCO modulus representing a stable period calculation (e.g., 1/frequency).

In embodiments, the processor unit 212 includes a phase detector 432. The phase detector 432 may be configured to calculate for every line cycle a first order counter value difference, or phase error, between occurrence of a DCO terminal count (e.g., modulus) and the instantaneous DCO count. The phase detector 432 may then record this value to the SRAM 408 or other memory.

In embodiments, the processor unit 212 further includes a digital loop filter 436. The digital loop filter 436 is configured for every line cycle to calculate an additive or subtractive incremental count to the DCO modulus that is proportional to the phase error integral and save the updated DCO modulus to the SRAM 408, the DMA 412, or other memory. The digital loop filter 436 may also automatically reload the updated DCO modulus from volatile data memory after the terminal count is reached. These actions of the digital loop filter 436 results in a convergence of the timing occurrence of the DCO terminal count and the comparator 428 instantaneous DCO count to a minimum phase error. This minimum phase error serves as a criterion for stable lock conditions (e.g., with less than a 0.3 Hz/sec slip). The convergence event represents the zeroth phase of the time series.

In embodiments, the processor unit 212 may further include nonvolatile memory (NVM) 440. The nonvolatile memory 440 stores programs operational data required for proper function of the PIM 116. For example, the nonvolatile memory 440 may store one or more sets of voltage calibration scalars and current calibration scalars that are accessed for metering calculations during normal operation. The nonvolatile memory 440 may also store additional scalars describing the characteristic response of the current transformers 236 at different current levels. These scalars may be then used to allow a single-point calibration for equipment under test.

The transformation of the time series (sₙ) in preparation of determining energy-related parameters, such as at least one of downstream real power, apparent power, power factor or crest factor calculation are performed by the processor unit 212. For example, sₙ for current may be transformed by linear interpolation to restore sampling coherency (e.g., phase relationship) with their respective time series for voltage, as shown in equation 1:
${s}_{n} ← \left({s}_{n}-\frac{\left({s}_{n}-{s}_{n - 1}\right)}{{τ}_{adc}}\right)$ (Equation 1)
where is *τ_{adc}* is a time of analog to digital (AD) conversion, which is precalculated and proportional to the AD conversion time and relative AD channel displacement from the voltage channel. The time series sₙ may also be transformed by a calibration scalar, as shown in equation 2:
${s}_{n} ← {μ}_{g} ∗ {s}_{n}$ (Equation 2)
where *µ_{g}* is the calibration scalar, a decimal number determined at factory calibration and saved to nonvolatile memory.

In embodiments, the time series sₙ may be transformed using a first order recursive filter structure as shown in equation 3:
${x}_{n} ← {x}_{n - 1} + {β}_{f} ∗ \left({s}_{n}-{x}_{n - 1}\right) , 0 < {β}_{f} < 1$ (Equation 3)
where *β_{f}* is a filter constant (*β_{f}*=1/2^{k}), which is used for a computational fast right shift operation compared to a floating-point multiplication.

In embodiments, the time series sₙ may be transformed using a cascaded integrator-comb (CIC) filter, as shown in in equations 4-6 below:
${x}^{c} = {s}_{n} - {s}_{n - M}$ (Equation 4)
${x}^{i} ← {x}^{i} + {x}^{c}$ (Equation 5)
${x}_{n} = \frac{{x}^{i}}{M}$ (Equation 6)
where M is the number of samples per stage.

In embodiments, the DC offset, or DC bias, may be calculated for each time series *sₙ* from its mean error integral over N samples as shown in equation 7 below:
$\overline{x} ← \overline{x} + {β}_{m} ∗ {\sum }_{0}^{N - 1} {s}_{n} , 0 < {β}_{m} < 0.0125$ (Equation 7)
where N is the number of samples and *βₘ* is a filter constant (e.g., *βₘ*=1/2^{k}), which is used for a computational fast right shift as compared to a floating-point multiplication (e.g., similar to filter constant *β_{f}* in equation 3). It should be noted that for sinusoidal signals, the mean *x̅* =0 over the integer line cycle, and N samples correspond to exactly an integer line cycle.

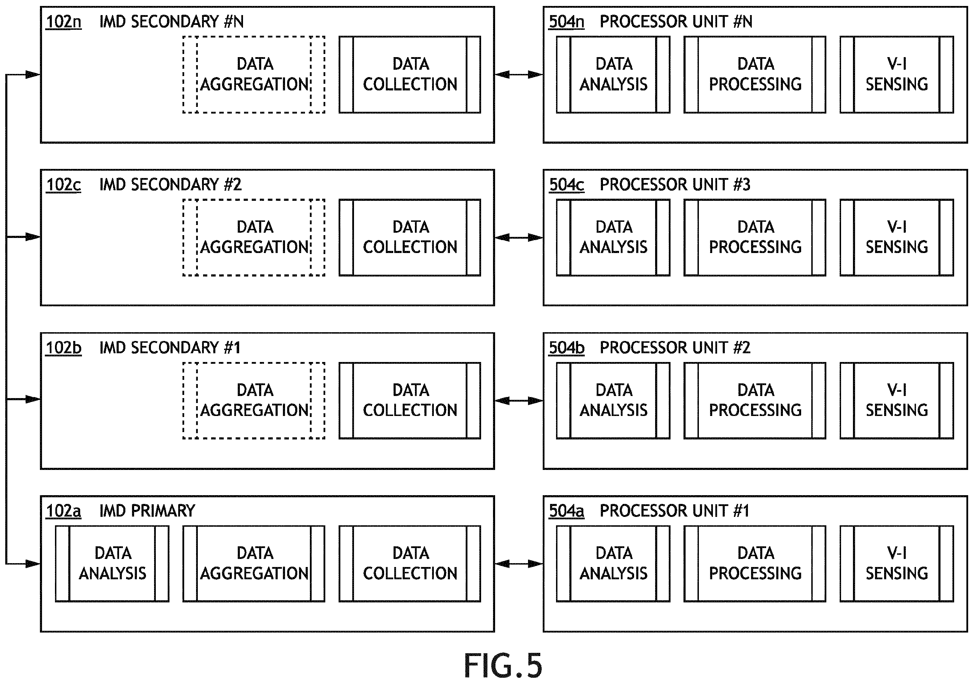

Referring to FIG. 5, a block diagram of the power distribution system 100 with multiple IMDs 120 be communicatively linked or otherwise have interconnectivity with each other, in accordance with the present invention is shown. For example, the power distribution system 100 may include a single primary IMD 120a, and multiple secondary IMDs 120b-n. Each IMD 120 may then receive data or data analysis from a respective processor units 504a-n (e.g., processor units from the PIM 116, from the POM 112, or other processor units within the power distribution system 100). For instance, each secondary IMD 120b-n may be operatively coupled to processor units 504b-n (e.g., PIMs 116) that are capable of voltage current (V-I) sensing, and process and analyze data based on the sensed current and voltage. These data are then sent to the respective secondary IMD 120 b-n, which performs data collection and data aggregation steps based on the received data. Data from the secondary IMDs 120b-n may then be sent to the primary IMD 120a which may further perform data analysis on the collected analysis and/or report on the data.

In an example of the collective action between the primary IMD 120a and the secondary IMDs 120b-n, the secondary IMDs 120b-n may first collect time series data sₙ from each respective processor unit 504b-n. The time series values may be communicated from the processor units 504b-n to the respective IMD 120b-n in a compressed or uncompressed encoding schema. The primary IMD 120a then collects, coordinates, and correlates the time series data sₙ collected by each secondary IMD 120b-n. At some point, the time series values may be encoded by sending an initial value followed by a series of lower resolution differences of successive sample values. For example, the nearly sinusoidal time series values may be encoded by sending sinusoid phase and amplitude values followed by a series of lower resolution error values. These time series values may be communicated between IMDs 120a-n via a dedicated web application programming interface (API) node.

In some embodiments, secondary IMDs 120b-n may aggregate data from multiple processor units 504 before communicating their data to the primary IMD 120a. One or more IMDs 120a-n may also initiate a process to correlate the time series of the processor units 504a-n. One or more IMDs 120a-n may also collect time series data from the processor units 504a-n collected during different time cycles. In embodiments, data analysis from each processor unit 504a-n may be refreshed every consecutive N-cycles or refresh interval. Data analysis from the primary IMD 120a may also be refreshed every consecutive aggregation interval.

As part of the data analysis performed by the IMD 120a-n and/or the processor units 504a-n, the processor unit root mean square (RMS) values may be calculated for data received by the voltage and current time series *xₙ* over N samples as shown in equation 8:
${X}_{rms} = {μ}_{g} ∗ \sqrt{\frac{{\sum }_{0}^{N - 1} {\left({x}_{n}-\overline{x}\right)}^{2}}{N}}$ (Equation 8)
wherein a sample size N=2^{k} is preferred. *x̅* is calculated as in equation 7, and the calibration scalars are decimal numbers determined at initial calibration (e.g., factory calibration) and saved to nonvolatile memory 440.

The aggregate RMS for the primary IMD 120a may be calculated for the M-set of time series ${x}_{n}^{m}$ for current over N samples as shown in equation 9:
${X}_{rms} = \sqrt{\frac{{\sum }_{0}^{N - 1} {\left(\left({μ}_{g}^{0}∗\left({x}_{n}^{0}-\overline{{x}^{0}}\right)\right)+\left({μ}_{g}^{1}∗\left({x}_{n}^{1}-\overline{{x}^{1}}\right)\right)+…+\left({μ}_{n}^{m}∗\left({x}_{n}^{m}-\overline{{x}^{m}}\right)\right)\right)}^{2}}{N}}$ (Equation 9)
where *x̅^̅{̅m̅}̅* is calculated similarly as in equation 7.

Real power may be calculated as the dot product of voltage and current time series *vₙ* and *iₙ* over N samples as shown in equation 10, such as an instantaneous voltage and instantaneous current:
${P}_{W} = {\sum }_{0}^{N - 1} {v}_{n} ∗ {i}_{n}$ (Equation 10).

Apparent power may be calculated as the product of voltage and current RMS (e.g., *P_{VA} = Vᵣₘₛ * Iᵣₘₛ*)*.* The power factor may be calculated as the quotient of real power and apparent power (e.g., *PF = P_{W}*/*P_{VA}*)*.* The Crest Factor may be calculated as the quotient of average peak instantaneous samples of time series sₙ (e.g., from equations 1-3) over P integer periods and respective RMS values (e.g., from equations 8-9) over equivalent integer periods, as shown in equations 11 and 12, as shown below:
${\overline{X}}_{pk} = {\sum }_{0}^{P - 1} \frac{max {s}_{n}}{M}$ (Equation 11)
$CF = {\overline{X}}_{pk} / {X}_{rms}$ (Equation 12)
where the mean peak instantaneous sample is used to reduce sensitivity to measurement corruption from voltage transients that may be coupled into the system.

In embodiments, energy may be calculated from the trapezoidal integral of real power. Accumulated data, such as energy, may be communicated back to the processor unit 504 for storage in nonvolatile memory 440.

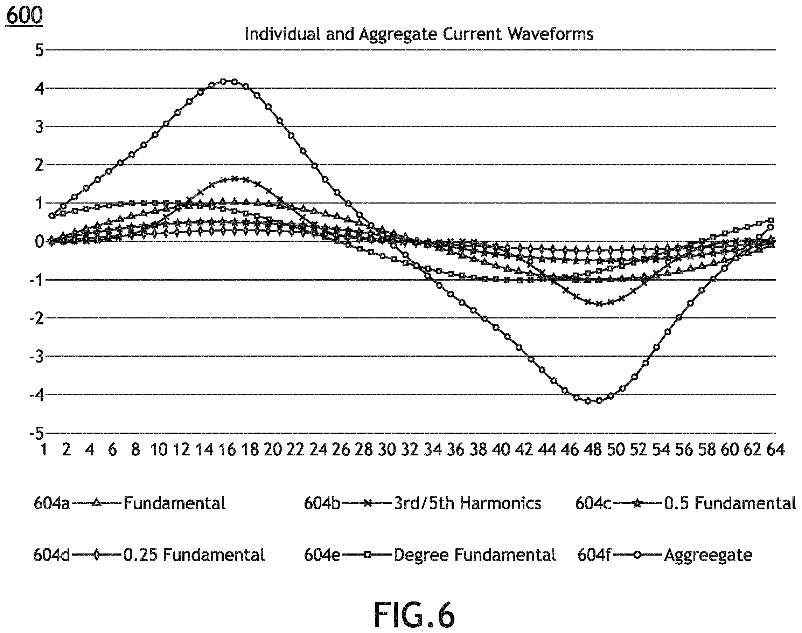

Referring to FIG. 6, discrete and aggregate determination of current waveforms are demonstrated in graph form, in accordance with the invention are shown. Multiple secondary IMDs 120b-n may collect current data from processor units 504b-n. These individual data series sₙ may differ considerably from each other, as demonstrated by the individual plots 604a-e of the graph (e.g., fundamental waveform plot 604a, 3^{rd}/5^{th} harmonic plot 604b, 0.5 fundamental plot 604c, 0.25 fundamental plot 604d, and 45-degree fundamental plot 604e). Data from each plot was then combined (e.g., via the primary IMD 120a) to calculate an aggregate current waveform plot 604f.

The ability of the IMD 120 to calculate aggregate waveforms (e.g., current or voltage) reduces the complexity and costs of a power distribution system 100 and other current PSD systems having waveform computation requirements. For example, the power distribution system 100 of the current invention saves installation costs by eliminating current transformer installation and associated electronics per input leg. In another example, this current power distribution system 100 simplifies installation by eliminating local wiring and mounting of input current transformers, and further frees up input connection space typically used by relatively larger input current transformers. The current power distribution system 100 provides greater optimization and homogeneity of measurement technique more conducive to automated data collection and sorting methods for improved power usage effectiveness (PUE) compared to previous disparate PSD systems, e.g., resulting in less energy consumption and lower utility charge back for collocated users. The current power distribution system 100 also tracks and/or troubleshoots groupings of loads, such as load groups based on server types, batched operations, and stressed loads. These abilities help users support sustainability goals by allowing users to optimize power usage and reduce stranded capacity through power management. The power distribution system 100 may be configured to, based on virtualized information, isolate groups of servers/consumers to identify performance or risk behaviors as well as make decisions to switch rack loads to support different availability levels. The power distribution system 100 may also be configured to assign loads an electronic ID so that once connected to the data center power infrastructure, the load can be readily assigned to predefined consumer and/or type groupings.

As previously stated, the IMD 120, the POM 112, and the PIM 116 may each be considered a power module. Although FIG. 1 presents the IMD 120, the POM 112, and the PIM 116 as separately defined components of the power distribution system 100, the IMD 120, the POM 112, and the PIM 116 may include one or more, or all, components of the IMD 120, the POM 112 and the PIM 116, and may perform one or more, or all, functions of the IMD 120, the POM 112, and the PIM 116. For example, POM 112 may include similar components and architecture of the PIM 116 as shown in FIG. 2 and FIG. 4. Therefore, the above description should not be interpreted as a limitation on the embodiments of the present invention but merely as an illustration.

It is further contemplated that a first power module (one or more of IMD 120, the POM 112, and the PIM 116) associated with a first load may be communicatively coupled with a second power module (one or more of IMD 120, the POM 112, and the PIM 116) associated with a second load in order to aggregate a time series value for the first load and a time series value for the second load. The aggregate time series value may be used to determine an energy-related parameter, such as at least one of current, voltage, RMS current, RMS voltage, real power, apparent power, power factor, or energy.

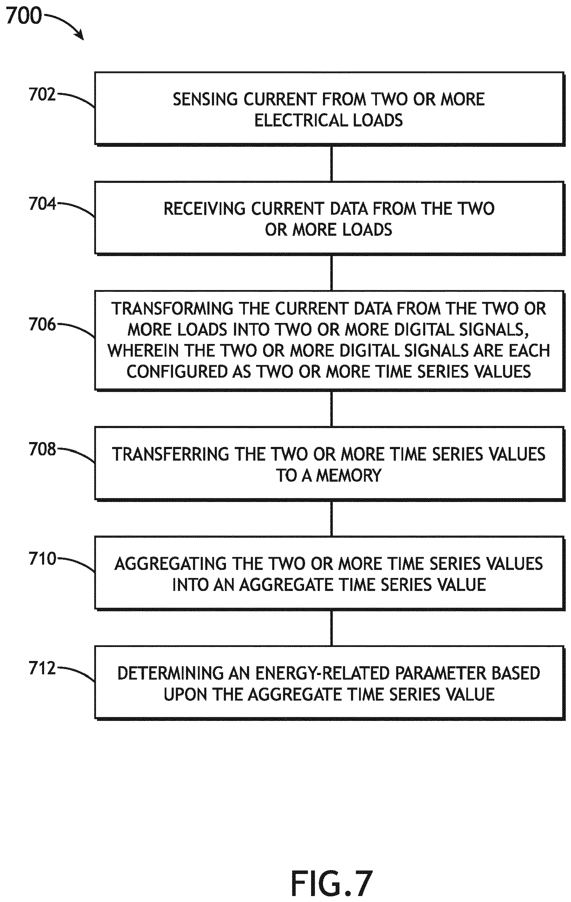

Referring to FIG. 7, a flow diagram illustrating a method for virtualizing energy metering, in accordance with the invention is shown. The method may be utilized by any PSD system including but not limited to a power distribution system 100. The method 700 specifically describes metering of current, but may also be used for the metering of any other power or energy metric including but not limited to voltage. It is contemplated that method 700 may be performed by a first power module (one or more of IMD 120, the POM 112, and the PIM 116) associated with a first load that may be communicatively coupled with a second power module (one or more of IMD 120, the POM 112, and the PIM 116) associated with a second load in order to aggregate a time series value for the first load and a time series value for the second load.

The method 700 includes a step 710 of sensing current or voltage drawn from two or more electrical loads (e.g., a first load and a second load). Each power module may include current sensing/conditioning circuitry that can sense a current load that is drawn by the corresponding load (the first load or second load).

The method 700 further includes a step 720 of receiving current data from the two or more loads. For example, each current sensing/conditioning circuitry may sense the respective current (e.g., via current transformers 236 and burden resistors 244) from the respective load and send current data (e.g., an amount of current obtained by the current sensing/conditioning circuitry 204) to the respective processor unit for each power module.

The method 700 further includes a step 730 of transforming the current data from the two or more loads into two or more digital signals, wherein the two or more digital signals are each configured as two or more time series values. For example, current data signals may be converted via one or more ADCs 416, 418 into a digital signal that is correlated to a time series via a phase lock loop formed from the frequency detector 424, digital controlled oscillator 410, phase detector 432, digital loop filter 436, and timers 420, along with other circuitry elements of the processor unit 212. The digitized signal may also be transformed by the processor unit of the power module via one or more methods/equations as described herein.

The method 700 further includes a step 740 of transferring the two or more time series values to a memory. For example, the time series values may be stored within the processor unit 212 via nonvolatile memory 440, or volatile memory (e.g., DMA 412, SRAM 408), or within the IMD 120 via flash memory 316 or DDR memory 320. Once in memory, the time series value may be accessed for further analysis and/or reporting.

In embodiments, the method 700 further includes a step 750 of aggregating the two or more time series values (a time series value for a first load and a time series value for a second load) into an aggregate time series value. For example, the time series values from each load may be combined to form an aggregated time value series that represents the summation of current waveforms of loads (e.g., as represented by the aggregate current waveform plot 604f) that are flowing through the power distribution system 100.

The method includes a step 760 of determining an energy-related parameter based upon the aggregate time series value. For example, the aggregate time series value, or values, may be reported to a user display via the display interface 312. In another example, the aggregate time series value may be sent to a user mobile device via a Bluetooth or other communication waveform. The aggregate time series value may be transformed to determine an energy-related parameter, such as at least one of RMS current, real power, power factor, or energy.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this invention. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

The invention is defined by the appended claims.

## Claims

1. A system for virtualized energy metering, comprising:
a power distribution system (100), comprising:
a first power module (116), the first power module (116) including:
a first current sensing circuit (204) configured to determine an amount of current drawn by a first load and configured to send a first current data representative of the amount of current drawn by the first load; and
a first power module processor unit (212), wherein the first power module processor unit (212) of the first power module (116) is configured to:
receive the first current data from the first current sensing circuit (204);
transform the first current data from the first current sensing circuit (204) into a first digital signal, the first digital signal configured as a first time series value; and
transfer the first time series value to a first memory; and
a second power module, the second power module including:
a second current sensing circuit configured to determine an amount of current drawn by a second load and configured to send a second current data representative of the amount of current drawn by the second load;
a second power module processor unit, wherein the second power module processor unit of the second power module is configured to:
receive the second current data from the second current sensing circuit;
transform the second current data from the second current sensing circuit into a second digital signal, the second digital signal configured as a second time series value; and
transfer the second time series value to a second memory;
receive the first time series value from the first power module (116);
aggregate the first time series value from the first power module (116) and the second time series value from the second power module into an aggregate time series value **characterized in that**
aggregating the first time series value from the first power module (116) and the second time series value from the second power module comprises:
generating root mean square (RMS) values based on the data received by the voltage and current time series over the number of samples for each of the first power module (116) and the second power module; and
aggregating the RMS values for each of the first power module (116) and the second power module for an M-set of time series for current of the number of samples; and
determine an energy-related parameter based upon the aggregate time series value.

2. The system as claimed in claim 1, wherein the power distribution system (100) is configured to receive an AC input and provide an AC output to the first load.

3. The system as claimed in claim 1 or 2, wherein the energy-related parameter includes at least one of RMS current, real power, power factor, or energy.

4. The system as claimed in claim 1, 2 or 3, wherein the power distribution system (100) is at least one of a busway and tap box electrical system, a remote power panel, or a remote power distribution unit.

5. The system as claimed in claim 1, 2 or 3, wherein the first power module (116) is at least one of a power input module (116) , a power output module (112) , or an interchangeable monitoring device (120).

6. The system as claimed in claim 1, 2 or 3, wherein the first current sensing circuit (204) is operatively coupled to at least one or more current transformers.

7. The system as claimed in claim 1, 2 or 3 ,wherein the first power module processor unit (116) of the first power module is configured to transform the first current data via one or more analog-digital converters into the first digital signal, wherein the first digital signal is correlated to a time series via a phase lock loop.

8. The system as claimed in claim 1, 2 or 3, wherein the first power module (116) further comprises a first voltage sensing circuit (208) that is operatively connected to resistor
Network (232), wherein the resistor network (232) is coupled to each primary circuit of the power distribution system (100).

9. A method for virtualized energy metering, comprising:
sensing current from two or more loads;
receiving current data from the two or more loads;
transforming the current data from the two or more loads into two or more digital signals, wherein the two or more digital signals are each configured as two or more time series values;
transferring the two or more time series values to a memory;
aggregating the two or more time series values into an aggregate time series value, **characterized in that**
aggregating the first time series value from the first power module(116) and the second time series value from the second power module comprises:
generating root mean square (RMS) values based on the data received by the voltage and current time series over the number of samples for each of the first power module (116) and the second power module; and
aggregating the RMS values for each of the first power module (116) and the second power module for an M-set of time series for current of the number of samples; and
determining an energy-related parameter based upon the aggregate time series value.

10. The method as claimed in claim 9, wherein the system of any of claims 1-8 is used.

11. The method as claimed in claim 9 or 10, wherein the energy-related parameter includes at least one of RMS current, power, power factor, or energy.

12. The system of claim 1, wherein RMS values (Xrms) based on the data received by the voltage and current time series (x) over the number of samples (N) for each of the first power module and the second power module is calculated via Equation 1 as follows: ${X}_{rms} = {μ}_{g} ∗ \sqrt{\frac{{\sum }_{0}^{N - 1} {\left({x}_{n}-\overline{x}\right)}^{2}}{N}}$ wherein µg is a calibration scalar.

13. The system of claim 12, wherein the aggregating the RMS values (Xrms) for each of the first power module and the second power module for an M-set of time series for current over the number of samples (N) is calculated via Equation 2 as follows: ${X}_{rms} = \sqrt{\frac{{\sum }_{0}^{N - 1} {\left(\left({μ}_{g}^{0}∗\left({x}_{n}^{0}-\overline{{x}^{0}}\right)\right)+\left({μ}_{g}^{1}∗\left({x}_{n}^{1}-\overline{{x}^{1}}\right)\right)+…+\left({μ}_{n}^{m}∗\left({x}_{n}^{m}-\overline{{x}^{m}}\right)\right)\right)}^{2}}{N}} .$

14. The method of claim 9, wherein RMS values (Xrms) based on the data received by the voltage and current time series (x) over the number of samples (N) for each of the first power module and the second power module is calculated via Equation 1 as follows: ${X}_{rms} = {μ}_{g} ∗ \sqrt{\frac{{\sum }_{0}^{N - 1} {\left({x}_{n}-\overline{x}\right)}^{2}}{N}}$ wherein µg is a calibration scalar.

15. The method of claim 14, wherein the aggregating the RMS values (Xrms) for each of the first power module and the second power module for an M-set of time series for current over the number of samples (N) is calculated via Equation 2 as follows: ${X}_{rms} = \sqrt{\frac{{\sum }_{0}^{N - 1} {\left(\left({μ}_{g}^{0}∗\left({x}_{n}^{0}-\overline{{x}^{0}}\right)\right)+\left({μ}_{g}^{1}∗\left({x}_{n}^{1}-\overline{{x}^{1}}\right)\right)+…+\left({μ}_{n}^{m}∗\left({x}_{n}^{m}-\overline{{x}^{m}}\right)\right)\right)}^{2}}{N}} .$

## Patentansprüche

1. System zur virtualisierten Energiemessung, das Folgendes umfasst:
ein Leistungsverteilungssystem (100), umfassend:
ein erstes Leistungsmodul (116), wobei das erste Leistungsmodul (116) Folgendes aufweist:
eine erste Stromerfassungsschaltung (204), die dazu ausgelegt ist, eine Strommenge zu bestimmen, die von einer ersten Last aufgenommen wird, und dazu ausgelegt ist, erste Stromdaten zu senden, die die Strommenge repräsentieren, die von der ersten Last aufgenommen wird; und
eine erste Leistungsmodulprozessoreinheit (212), wobei die erste Leistungsmodulprozessoreinheit (212) des ersten Leistungsmoduls (116) ausgelegt ist zum:
Empfangen der ersten Stromdaten von der ersten Stromerfassungsschaltung (204);
Transformieren der ersten Stromdaten von der ersten Stromerfassungsschaltung (204) in ein erstes digitales Signal, wobei das erste digitale Signal als ein erster Zeitreihenwert konfiguriert ist; und
Übertragen des ersten Zeitreihenwerts in einen ersten Speicher; und
ein zweites Leistungsmodul, wobei das zweite Leistungsmodul Folgendes aufweist:
eine zweite Stromerfassungsschaltung, die dazu ausgelegt ist, eine Strommenge zu bestimmen, die von einer zweiten Last aufgenommen wird, und dazu ausgelegt ist, zweite Stromdaten zu senden, die die Strommenge repräsentieren, die von der zweiten Last aufgenommen wird;
eine zweite Leistungsmodulprozessoreinheit, wobei die zweite Leistungsmodulprozessoreinheit des zweiten Leistungsmoduls ausgelegt ist zum:
Empfangen der zweiten Stromdaten von der zweiten Stromerfassungsschaltung;
Transformieren der zweiten Stromdaten von der zweiten Stromerfassungsschaltung in ein zweites digitales Signal, wobei das zweite digitale Signal als ein zweiter Zeitreihenwert konfiguriert ist; und
Übertragen des zweiten Zeitreihenwerts in einen zweiten Speicher;
Empfangen des ersten Zeitreihenwerts von dem ersten Leistungsmodul (116);
Aggregieren des ersten Zeitreihenwerts von dem ersten Leistungsmodul (116) und des zweiten Zeitreihenwerts von dem zweiten Leistungsmodul zu einem aggregierten Zeitreihenwert, **dadurch gekennzeichnet, dass** das Aggregieren des ersten Zeitreihenwerts von dem ersten Leistungsmodul (116) und des zweiten Zeitreihenwerts von dem zweiten Leistungsmodul Folgendes umfasst:
Erzeugen von Effektivwerten (RMS) basierend auf den Daten, die durch die Spannungs- und Stromzeitreihe über die Anzahl von Abtastwerten für sowohl das erste Leistungsmodul (116) als auch das zweite Leistungsmodul empfangen werden; und
Aggregieren der RMS-Werte für sowohl das erste Leistungsmodul (116) als auch das zweite Leistungsmodul für einen M-Satz von Zeitreihen für Strom der Anzahl von Abtastungen; und
Bestimmen eines energiebezogenen Parameters basierend auf dem aggregierten Zeitreihenwert.

2. System nach Anspruch 1, wobei das Leistungsverteilungssystem (100) dazu ausgelegt ist, einen Wechselstromeingang zu empfangen und einen Wechselstromausgang für die erste Last bereitzustellen.

3. System nach Anspruch 1 oder 2, wobei der energiebezogene Parameter RMS-Strom und/oder Wirkleistung und/oder Leistungsfaktor und/oder Energie beinhaltet.

4. System nach Anspruch 1, 2 oder 3, wobei das Leistungsverteilungssystem (100) mindestens eines aus einem elektrischen Sammelschienen- und Abzweigkastensystem, einem entfernten Leistungsverteilungspanel oder einer entfernten Leistungsverteilungseinheit ist.

5. System nach Anspruch 1, 2 oder 3, wobei das erste Leistungsmodul (116) ein Leistungseingangsmodul (116) und/oder ein Leistungsausgangsmodul (112) und/oder eine austauschbare Überwachungsvorrichtung (120) ist.

6. System nach Anspruch 1, 2 oder 3, wobei die erste Stromerfassungsschaltung (204) operativ mit mindestens einem oder mehreren Stromwandlern gekoppelt ist.

7. System nach Anspruch 1, 2 oder 3, wobei die erste Leistungsmodulprozessoreinheit (116) des ersten Leistungsmoduls dazu ausgelegt ist, die ersten aktuellen Daten über einen oder mehrere Analog-Digital-Wandler in das erste digitale Signal zu transformieren, wobei das erste digitale Signal über eine Phasenregelschleife mit einer Zeitreihe korreliert wird.

8. System nach Anspruch 1, 2 oder 3, wobei das erste Leistungsmodul (116) ferner eine erste Spannungserfassungsschaltung (208) umfasst, die mit dem Widerstandsnetzwerk (232) wirkverbunden ist, wobei das Widerstandsnetzwerk (232) mit jeder Primärschaltung des Leistungsverteilungssystems (100) gekoppelt ist.

9. Verfahren zur virtualisierten Energiemessung, das Folgendes umfasst:
Erfassen von Strom von zwei oder mehr Lasten;
Empfangen aktueller Daten von den zwei oder mehr Lasten;
Transformieren der aktuellen Daten von den zwei oder mehr Lasten in zwei oder mehr digitale Signale, wobei die zwei oder mehr digitalen Signale jeweils als zwei oder mehr Zeitreihenwerte konfiguriert sind;
Übertragen der zwei oder mehr Zeitreihenwerte in einen Speicher;
Aggregieren der zwei oder mehr Zeitreihenwerte zu einem aggregierten Zeitreihenwert, **dadurch gekennzeichnet, dass** das Aggregieren des ersten Zeitreihenwerts von dem ersten Leistungsmodul (116) und des zweiten Zeitreihenwerts von dem zweiten Leistungsmodul Folgendes umfasst:
Erzeugen von Effektivwerten (RMS) basierend auf den Daten, die durch die Spannungs- und Stromzeitreihe über die Anzahl von Abtastwerten für sowohl das erste Leistungsmodul (116) als auch das zweite Leistungsmodul empfangen werden; und
Aggregieren der RMS-Werte für sowohl das erste Leistungsmodul (116) als auch das zweite Leistungsmodul für einen M-Satz von Zeitreihen für Strom der Anzahl von Abtastungen; und
Bestimmen eines energiebezogenen Parameters basierend auf dem aggregierten Zeitreihenwert.

10. Verfahren nach Anspruch 9, wobei das System nach einem der Ansprüche 1-8 verwendet wird.

11. Verfahren nach Anspruch 9 oder 10, wobei der energiebezogene Parameter RMS-Strom und/oder Leistung und/oder Leistungsfaktor und/oder Energie beinhaltet.

12. System nach Anspruch 1, wobei RMS-Werte (Xrms) basierend auf den Daten, die durch die Spannungs- und Stromzeitreihe (x) über die Anzahl von Abtastwerten (N) für sowohl das erste Leistungsmodul als auch das zweite Leistungsmodul empfangen werden, über Gleichung 1 wie folgt berechnet werden: ${x}_{rms} = {μ}_{g} ∗ \sqrt{\frac{{\sum }_{0}^{N - 1} {\left({x}_{n}-\overline{x}\right)}^{2}}{N}}$ wobei µg ein Kalibrierungsskalar ist.

13. System nach Anspruch 12, wobei das Aggregieren der RMS-Werte (Xrms) für sowohl das erste Leistungsmodul als auch das zweite Leistungsmodul für einen M-Satz von Zeitreihen für Strom über die Anzahl von Abtastungen (N) über Gleichung 2 wie folgt berechnet wird: ${x}_{rms} = \sqrt{\frac{{\sum }_{0}^{N - 1} {\left(\left({μ}_{g}^{0}∗\left({x}_{n}^{0}-\overline{{x}^{0}}\right)+\left({μ}_{g}^{1}∗\left({x}_{n}^{1}-\overline{{x}^{1}}\right)\right)+…+\left({μ}_{n}^{m}∗\left({x}_{n}^{m}-\overline{{x}^{m}}\right)\right)\right)\right)}^{2}}{N}} .$

14. Verfahren nach Anspruch 9, wobei RMS-Werte (Xrms) basierend auf den Daten, die durch die Spannungs- und Stromzeitreihe (x) über die Anzahl von Abtastwerten (N) für sowohl das erste Leistungsmodul als auch das zweite Leistungsmodul empfangen werden, über Gleichung 1 wie folgt berechnet werden: ${x}_{rms} = {μ}_{g} ∗ \sqrt{\frac{{\sum }_{0}^{N - 1} {\left({x}_{n}-\overline{x}\right)}^{2}}{N}}$ wobei µg ein Kalibrierungsskalar ist.

15. Verfahren nach Anspruch 14, wobei das Aggregieren der RMS-Werte (Xrms) für sowohl das erste Leistungsmodul als auch das zweite Leistungsmodul für einen M-Satz von Zeitreihen für Strom über die Anzahl von Abtastungen (N) über Gleichung 2 wie folgt berechnet wird: ${x}_{rms} = \sqrt{\frac{{\sum }_{0}^{N - 1} {\left(\left({μ}_{g}^{0}∗\left({x}_{n}^{0}-\overline{{x}^{0}}\right)+\left({μ}_{g}^{1}∗\left({x}_{n}^{1}-\overline{{x}^{1}}\right)\right)+…+\left({μ}_{n}^{m}∗\left({x}_{n}^{m}-\overline{{x}^{m}}\right)\right)\right)\right)}^{2}}{N}} .$

## Revendications

1. Système pour comptage d'énergie virtualisé, comprenant :
un système de distribution de puissance (100), comprenant :
un premier module de puissance (116), le premier module de puissance (116) incluant :
un premier circuit de détection de courant (204) configuré pour déterminer une quantité de courant soutirée par une première charge et configuré pour envoyer des premières données de courant représentatives de la quantité de courant soutirée par la première charge ; et
une unité processeur de premier module de puissance (212), dans lequel l'unité processeur de premier module de puissance (212) du premier module de puissance (116) est configurée pour :
recevoir les premières données de courant en provenance du premier circuit de détection de courant (204) ;
transformer les premières données de courant en provenance du premier circuit de détection de courant (204) en un premier signal numérique, le premier signal numérique étant configuré sous forme de première valeur de série chronologique ; et
transférer la première valeur de série chronologique à une première mémoire ; et
un second module de puissance, le second module de puissance incluant :
un second circuit de détection de courant configuré pour déterminer une quantité de courant soutirée par une seconde charge et configuré pour envoyer des secondes données de courant représentatives de la quantité de courant soutirée par le seconde charge ;
une unité processeur de second module de puissance, dans lequel l'unité processeur de second module de puissance du second module de puissance est configurée pour :
recevoir les secondes données de courant en provenance du second circuit de détection de courant ;
transformer les secondes données de courant en provenance du second circuit de détection de courant en un second signal numérique, le second signal numérique étant configuré sous forme de seconde valeur de série chronologique ; et
transférer la seconde valeur de série chronologique à une seconde mémoire ;
recevoir la première valeur de série chronologique en provenance du premier module de puissance (116) ;
agréger la première valeur de série chronologique en provenance du premier module de puissance (116) et la seconde valeur de série chronologique en provenance du second module de puissance en une valeur de série chronologique agrégée, **caractérisé en ce que** le fait d'agréger la première valeur de série chronologique en provenance du premier module de puissance (116) et la seconde valeur de série chronologique en provenance du second module de puissance comprend les faits suivants :
générer des valeurs de moyenne quadratique (Root Mean Square, RMS) sur la base des données reçues par la série chronologique de tension et de courant par rapport au nombre d'échantillons pour chacun du premier module de puissance (116) et du second module de puissance ; et
agréger les valeurs RMS pour chacun du premier module de puissance (116) et du second module de puissance pour un ensemble M de séries chronologiques pour courant du nombre d'échantillons ; et
déterminer un paramètre connexe à l'énergie sur la base de la valeur de série chronologique agrégée.

2. Système tel que revendiqué dans la revendication 1, dans lequel le système de distribution de puissance (100) est configuré pour recevoir une entrée CA et fournir une sortie CA à la première charge.

3. Système tel que revendiqué dans la revendication 1 ou 2, dans lequel le paramètre connexe à l'énergie inclut au moins un élément parmi courant RMS, puissance active, facteur de puissance, ou énergie.

4. Système tel que revendiqué dans la revendication 1, 2, ou 3, dans lequel le système de distribution de puissance (100) est au moins un composant parmi un système électrique à barre blindée et à boîte de dérivation, un panneau de puissance à distance, ou une unité de distribution de puissance à distance.

5. Système tel que revendiqué dans la revendication 1, 2, ou 3, dans lequel le premier module de puissance (116) est au moins un composant parmi un module d'entrée de puissance (116), un module de sortie de puissance (112), ou un dispositif de surveillance interchangeable (120).

6. Système tel que revendiqué dans la revendication 1, 2, ou 3, dans lequel le premier circuit de détection de courant (204) est couplé opérationnellement au moins à un ou à plusieurs transformateurs de courant.

7. Système tel que revendiqué dans la revendication 1, 2, ou 3, dans lequel l'unité processeur de premier module de puissance (116) du premier module de puissance est configurée pour transformer les premières données de courant par l'intermédiaire d'un ou de plusieurs convertisseurs analogiques-numériques en le premier signal numérique, dans lequel le premier signal numérique est corrélé à une série chronologique par l'intermédiaire d'une boucle à verrouillage de phase.

8. Système tel que revendiqué dans la revendication 1, 2, ou 3, dans lequel le premier module de puissance (116) comprend en outre un premier circuit de détection de tension (208) qui est connecté opérationnellement à un réseau de résistances (232), dans lequel le réseau de résistances (232) est couplé à chaque circuit primaire du système de distribution de puissance (100).

9. Procédé pour comptage d'énergie virtualisé, comprenant les faits suivants :
détecter un courant en provenance de deux ou de plus de deux charges ;
recevoir des données de courant en provenance des deux ou des plus de deux charges ;
transformer les données de courant en provenance des deux ou des plus de deux charges en deux ou plus de deux signaux numériques, dans lequel les deux ou plus de deux signaux numériques sont chacun configurés sous forme de deux ou de plus de deux valeurs de série chronologique ;
transférer les deux ou plus de deux valeurs de série chronologique à une mémoire ;
agréger les deux ou plus de deux valeurs de série chronologique en une valeur de série chronologique agrégée, **caractérisé en ce que** le fait d'agréger la première valeur de série chronologique en provenance du premier module de puissance(116) et la seconde valeur de série chronologique en provenance du second module de puissance comprend les faits suivants :
générer des valeurs de moyenne quadratique (Root Mean Square, RMS) sur la base des données reçues par la série chronologique de tension et de courant par rapport au nombre d'échantillons pour chacun du premier module de puissance (116) et du second module de puissance ; et
agréger les valeurs RMS pour chacun du premier module de puissance (116) et du second module de puissance pour un ensemble M de séries chronologiques pour courant du nombre d'échantillons ; et
déterminer un paramètre connexe à l'énergie sur la base de la valeur de série chronologique agrégée.

10. Procédé tel que revendiqué dans la revendication 9, dans lequel le système de quelconques des revendications 1 à 8 est utilisé.

11. Procédé tel que revendiqué dans la revendication 9 ou 10, dans lequel le paramètre connexe à l'énergie inclut au moins un élément parmi courant RMS, puissance, facteur de puissance, ou énergie.

12. Système de la revendication 1, dans lequel des valeurs RMS (Xrms) basées sur les données reçues par la série chronologique de tension et de courant (x) par rapport au nombre d'échantillons (N) pour chacun du premier module de puissance et du second module de puissance sont calculées par l'intermédiaire de l'équation 1 comme suit : ${x}_{rms} = {μ}_{g} ∗ \sqrt{\frac{{\sum }_{0}^{N - 1} {\left({x}_{n}-\overline{x}\right)}^{2}}{N}}$ µg étant un scalaire d'étalonnage.

13. Système de la revendication 12, dans lequel le fait d'agréger les valeurs RMS (Xrms) pour chacun du premier module de puissance et du second module de puissance pour un ensemble M de séries chronologiques pour courant par rapport au nombre d'échantillons (N) est calculé par l'intermédiaire de l'équation 2 comme suit : ${x}_{rms} = \sqrt{\frac{{\sum }_{0}^{N - 1} {\left(\left({μ}_{g}^{0}∗\left({x}_{n}^{0}-\overline{{x}^{0}}\right)+\left({μ}_{g}^{1}∗\left({x}_{n}^{1}-\overline{{x}^{1}}\right)\right)+…+\left({μ}_{n}^{m}∗\left({x}_{n}^{m}-\overline{{x}^{m}}\right)\right)\right)\right)}^{2}}{N}} .$

14. Procédé de la revendication 9, dans lequel des valeurs RMS (Xrms) basées sur les données reçues par la série chronologique de tension et de courant (x) par rapport au nombre d'échantillons (N) pour chacun du premier module de puissance et du second module de puissance sont calculées par l'intermédiaire de l'équation 1 comme suit : ${x}_{rms} = {μ}_{g} ∗ \sqrt{\frac{{\sum }_{0}^{N - 1} {\left({x}_{n}-\overline{x}\right)}^{2}}{N}}$ µg étant un scalaire d'étalonnage.

15. Procédé de la revendication 14, dans lequel le fait d'agréger les valeurs RMS (Xrms) pour chacun du premier module de puissance et du second module de puissance pour un ensemble M de séries chronologiques pour courant par rapport au nombre d'échantillons (N) est calculé par l'intermédiaire de l'équation 2 comme suit : ${x}_{rms} = \sqrt{\frac{{\sum }_{0}^{N - 1} {\left(\left({μ}_{g}^{0}∗\left({x}_{n}^{0}-\overline{{x}^{0}}\right)+\left({μ}_{g}^{1}∗\left({x}_{n}^{1}-\overline{{x}^{1}}\right)\right)+…+\left({μ}_{n}^{m}∗\left({x}_{n}^{m}-\overline{{x}^{m}}\right)\right)\right)\right)}^{2}}{N}} .$
